# EUROPÄISCHE PATENTANMELDUNG

(11) **EP 1 657 752 A1**
(43) Veröffentlichungstag der Anmeldung: **17.05.2006**
(21) Anmeldenummer: 05024763.4
(22) Anmeldetag: 12.11.2005
(51) Int. Cl.: H01L 27/082, H01L 21/8222

(54) **Integrierte Schaltung und Verfahren zur Herstellung einer integrierten Schaltung auf einem Halbleiterplättchen**

(30) Priorität: 16.11.2004 DE 102004055183
(71) Anmelder: ATMEL Germany GmbH, 74072 Heilbronn (DE)
(72) Erfinder: Bromberger, Christoph, Dipl.-Phys., 74074 Heilbronn (DE)

(57) **Zusammenfassung**

Verfahren zur Herstellung einer integrierten Schaltung auf einem Halbleiterplättchen, wobei
- ein erster Bipolartransistor (Q1) mit einem ersten Kollektorbereich (1', 2') eines ersten Leitungstyps und
- ein zweiter Bipolartransistor (Q2) mit einem zweiten Kollektorbereich (1, 2) dieses ersten Leitungstyps erzeugt werden,
indem
- der erste Kollektorbereich (1', 2') durch eine erste Kollektorepitaxie und nachfolgend eine zweite Kollektorepitaxie aufgewachsen wird, und
- der zweite Kollektorbereich (1, 2) auch durch diese erste Kollektorepitaxie und diese zweite Kollektorepitaxie aufgewachsen wird, und
- in den ersten Kollektorbereich (1', 2') nach dieser ersten Kollektorepitaxie und vor dieser zweiten Kollektorepitaxie Dotanden des ersten Leitungstyps derart eingebracht werden, dass eine erste Dotierstoffkonzentration in einer durch diese erste Kollektorepitaxie aufgewachsenen ersten Epitaxieschicht (1') des ersten Kollektorbereichs (1', 2') eine zweite Dotierstoffkonzentration in einer durch diese erste Kollektorepitaxie aufgewachsenen ersten Epitaxieschicht (1) des zweiten Kollektorbereichs (1, 2) übersteigt.

## Beschreibung

Die vorliegende Erfindung betrifft eine Integrierte Schaltung und ein Verfahren zur Herstellung einer integrierten Schaltung auf einem Halbleiterplättchen.

In Halbleitertechnologien werden vertikale Bipolartransistoren unterschiedlicher Spannungsfestigkeit und Frequenztauglichkeit zur Verfügung gestellt. Hierbei steigt im Allgemeinen die Spannungsfestigkeit mit sinkender Kollektordotierung. Ebenfalls führt eine geringere Kollektordotierung zu einer geringeren Grenzfrequenz.

Insbesondere im Hochfrequenzbereich ist das Verfahren des selektiv implantierten Kollektors bekannt. Hierbei werden aus einer einheitlichen Kollektorepitaxie ein erstes und ein zweites Halbleitergebiet erzeugt, aus welchem ersten Halbleitergebiet der Kollektor eines ersten Bipolartransistors mit hoher Spannungsfestigkeit und geringerer Frequenztauglichkeit, und aus welchem zweiten Halbleitergebiet der Kollektor eines zweiten Bipolartransistors mit geringerer Spannungsfestigkeit und besserer Frequenztauglichkeit herausgebildet werden. Hierzu wird das zweite Halbleitergebiet örtlich begrenzt mit einer zusätzlichen Kollektorimplantation (siC - selectiv implanted collector) versehen. Durch diese selektive Kollektorimplantation wird die Dotierstoffkonzentration im zweiten Halbleitergebiet über die Dotierstoffkonzentration im ersten Halbleitergebiet angehoben.
pn-Übergänge in Halbleitern existieren insbesondere als "lange" oder als "kurze" Dioden. Bei einer "langen" p-n-n⁺-Diode endet die Raumladungszone bei Sperrspannungen, wie sie beim normalen Betriebsbedingungen an dem pn-Übergang anliegen, n-seitig im n⁻-Gebiet, während sie bei "kurzen" Dioden auf das n⁺-Gebiet durchgreift. Durch den Durchgriff wird die Sperrfähigkeit "kurzer" Dioden gegenüber der Sperrfähigkeit einer "langen" Diode mit denselben Dotierstoffniveaus reduziert. Für einen Bipolartransistor mit gegebener Kollektor-Basis-Durchbruchsspannung ist daher eine bestimmte Ausdehnung der Kollektor-Driftzone nötig und erfordert mithin eine bestimmte Dicke der Kollektorepitaxie.

Umgekehrt ist insbesondere im Hochfrequenzbereich der Kollektorwiderstand ein wesentliches Kriterium für die Qualität des Bipolartransistors. Ein Teil des Kollektorwiderstandes ist der Widerstand eines eventuellen, unter normalen Betriebsbedingungen nicht ausgeräumten Anteils der Kollektor-Driftzone. Durch eine hinreichend hohe selektive Kollektorimplantation wird im Allgemeinen die Ausdehnung der Kollektor-Raumladungszone bei der gewünschten Betriebsbedingung reduziert. Da man bei Festlegung der Dicke der Kollektorepitaxie auf die Bedürfnisse bei dem höher sperrenden Transistor Rücksicht nehmen muss, wird häufig das zweite Halbleitergebiet im Betrieb des zweiten Bipolartransistors nicht vollständig ausgeräumt. Hierdurch wird der Kollektorwiderstand des zweiten Bipolartransistors nachteilig erhöht. Beispielsweise führen 120 nm nichtausgeräumter Kollektordriftzone mit einem üblichen Querschnitt von 20 x 0.6 µm² selbst bei der hohen Kollektordotierung von 1 e17 cm⁻³ noch zu einem zusätzlichen Kollektorwiderstand von 8 Ohm, was in vielen Fällen den Hauptteil des gesamten Kollektorwiderstandes ausmacht.

Aufgabe der vorliegenden Erfindung ist es, ein Verfahren anzugeben, mit dem sich auf einem einzigen Halbleiterplättchen unterschiedliche Transistoren mit unterschiedlichen Kollektordriftzonen realisieren lassen.

Diese Aufgabe wird erfindungsgemäß durch ein Verfahren mit den Merkmalen des Patentanspruches 1, durch eine integrierte Schaltung mit den Merkmalen des Patentanspruchs 6 und durch eine integrierte Kaskodenschaltung mit den Merkmalen des Patentanspruchs 10 gelöst. Vorteilhafte Weiterbildungen der Erfindung sind Gegenstand von Unteransprüchen.

Demzufolge werden in einem Verfahren zur Herstellung einer integrierten Schaltung auf einem Halbleiterplättchen ein erster Bipolartransistor mit einem ersten Kollektorbereich eines ersten Leitungstyps und ein zweiter Bipolartransistor mit einem zweiten Kollektorbereich dieses ersten Leitungstyps erzeugt. Der erste Leitungstyp ist dabei beispielsweise der n-Leitungstyp, wie dieser beispielsweise durch eine Phosphordotierung erzeugt werden kann.

Zur Herstellung wird der erste Kollektorbereich durch eine erste Kollektorepitaxie und eine zweite Kollektorepitaxie aufgewachsen. Dabei werden die erste Kollektorepitaxie und die zweite Kollektorepitaxie zu unterschiedlichen Zeiten durchgeführt, um zwischen diesen beiden Epitaxien zumindest einen Verfahrensschritt durchzuführen. Für die erste Kollektorepitaxie und die zweite Kollektorepitaxie wird beispielsweise das Halbleitermaterial Silizium abgeschieden. Weiterhin wird auch der zweite Kollektorbereich durch diese erste Kollektorepitaxie und diese zweite Kollektorepitaxie vorzugsweise mit demselben Halbleitermaterial aufgewachsen.

Das Wesen der Erfindung besteht nun darin, dass in den ersten Kollektorbereich nach dieser ersten Kollektorepitaxie und vor dieser zweiten Kollektorepitaxie Dotanden des ersten Leitungstyps derart eingebracht werden, dass eine erste Dotierstoffkonzentration in einer durch diese erste Kollektorepitaxie aufgewachsenen ersten Epitaxieschicht des ersten Kollektorbereichs eine zweite Dotierstoffkonzentration in einer durch diese erste Kollektorepitaxie aufgewachsenen ersten Epitaxieschicht des zweiten Kollektorbereichs übersteigt. Dabei können alle verwendbaren Dotanden des ersten Leitungstyps vorzugsweise ausschließlich in den ersten Kollektorbereich eingebracht werden. Zum Einbringen dieser Dotanden werden diese vorzugsweise in das Material der ersten Kollektorepitaxie im ersten Kollektorbereich implantiert, indem für diesen Implantationsverfahrensschritt der zweite Kollektorbereich durch eine Maske geschützt ist und somit nicht dotiert wird.

Durch diese selektive Dotierung wird hierbei ein hochdotierter, quasimetallischer "Sockel" unterhalb des Materials der zweiten Kollektorepitaxie des ersten Kollektorbereichs gebildet. Werden auch nach der zweiten Kollektorepitaxie Dotanden in das Material der zweiten Kollektorepitaxie in den ersten Kollektorbereich eingebracht, insbesondere implantiert, kann durch diese Verfahrensschritte eine niederresistiv angeschlossene, dünne und hochdotierte Kollektor-Driftzone ausgebildet werden.

Um andere Dotierstoffprofile und Dotierstoffgradienten des ersten Leitungstyps innerhalb des ersten Kollektorbereiches zu erzeugen, können in einer Weiterbildung der Erfindung noch eine dritte Kollektorepitaxie und gegebenenfalls noch weitere Kollektorepitaxien vorgesehen sein, zwischen denen jeweils ein oder mehrere weitere Verfahrensschritte, wie die Implantation von Dotierstoffen des ersten Leitungstyps, durchgeführt werden.

Die Erfindung weiterbildend ist zudem vorgesehen, dass in den ersten Kollektorbereich nach der zweiten Kollektorepitaxie Dotanden des ersten Leitungstyps derart eingebracht werden, dass eine dritte Dotierstoffkonzentration in einer durch diese zweite Kollektorepitaxie aufgewachsenen zweiten Epitaxieschicht des ersten Kollektorbereichs eine vierte Dotierstoffkonzentration in einer durch diese zweite Kollektorepitaxie aufgewachsenen zweiten Epitaxieschicht des zweiten Kollektorbereichs übersteigt.

Eine vorteilhafte Weiterbildung der Erfindung sieht vor, dass an den ersten Kollektorbereich angrenzend ein erster Basisbereich eines zweiten Leitungstyps mit einer Silizium-Germanium-Schicht aufgebracht wird und/oder an den zweiten Kollektorbereich angrenzend ein zweiter Basisbereich eines zweiten Leitungstyps mit einer Silizium-Germanium-Schicht aufgebracht wird.

Besonders bevorzugt wird zum selektiven Einbringen von Dotanden eine Maske, beispielsweise aus einem Photolack oder einem Oxid strukturiert aufgebracht und nachfolgend werden die Dotanden implantiert.

Eine besonders vorteilhafte Weiterbildung der Erfindung sieht vor, dass die erste Kollektorepitaxie eine laterale Festphasenepitaxie ist, wobei amorphes Silizium auf einer Silizidschicht und auf ein monokristallines Siliziumsubstrat aufgebracht und in einem Temperschritt ausgehend von dem als Kristallisationskeim wirkenden monokristallinem Siliziumsubstrat auskristallisiert wird. Zusätzlich kann zur Dotierung des Materials der ersten Kollektorepitaxie die Silizidschicht mit einem derartigen Fremdstoff versehen sein, der nachfolgend in den ersten Kollektorbereich eindiffundiert wird und dort als Dotierstoff des ersten Leitungstyps wirkt.

Ein weiterer wesentlicher Aspekt der Erfindung ist eine integrierte Schaltung auf einem Halbleiterplättchen. Diese integriert Schaltung weist zumindest einen ersten Bipolartransistor und einen zweiten Bipolartransistor auf. Dabei weist der erste Bipolartransistor einen ersten, durch eine erste Epitaxieschicht und eine zweite Epitaxieschicht aufgewachsenen Kollektorbereich eines ersten Leitungstyps auf. Der zweite Bipolartransistor weist einen zweiten, durch diese erste Epitaxieschicht und diese zweite Epitaxieschicht aufgewachsenen, zweiten Kollektorbereich desselben ersten Leitungstyps auf.

Die Ausbildung bewirkt, dass der erste Kollektorbereich eine erste Kollektordriftzone und der zweite Kollektorbereich eine zweite Kollektordriftzone aufweist, die im Wesentlichen durch die Dicke und die Dotierstoffkonzentration im Kollektorbereich bestimmt sind.

Besonders bevorzugt ist diese erste Kollektordriftzone gegenüber dieser zweiten Kollektordriftzone durch unterschiedliche Dotierstoffprofile in den Kollektorbereichen des ersten und zweiten Transistors strukturiert. Hierzu ist vorzugsweise vorgesehen, dass die erste Epitaxieschicht des ersten Kollektorbereiches eine höhere Dotierstoffkonzentration als die erste Epitaxieschicht des zweiten Kollektorbereichs aufweist.

Die Erfindung weiterbildend ist vorgesehen, dass die zweite Epitaxieschicht des ersten Kollektorbereichs zudem eine höhere Dotierstoffkonzentration als die zweite Epitaxieschicht des zweiten Kollektorbereichs aufweist. Die Gesamt Dotierstoffkonzentration im aktiven Kollektor des ersten Transistors ist entsprechend dieser Weiterbildung höher als die Dotierstoffkonzentration im aktiven Kollektor des zweiten Transistors. Demzufolge ist der erste Transistor bevorzugt für hochfrequente Signale und der zweite Transistor vorteilhafterweise für eine optimierte Spannungsfestigkeit geeignet.

In einer Ausgestaltung dieses Aspektes der Erfindung ist vorgesehen, dass der erste Kollektorbereich unmittelbar an eine Silizium-Germanium-Schicht eines ersten Basisbereiches eines zweiten Leitungstyps des ersten Bipolartransistors grenzt und/oder der zweite Kollektorbereich unmittelbar an eine Silizium-Germanium-Schicht eines zweiten Basisbereiches des zweiten Leitungstyps des zweiten Bipolartransistors grenzt.

Gemäß einer besonders bevorzugten Weiterbildung der Erfindung grenzt innerhalb des ersten Kollektorbereichs und/oder innerhalb des zweiten Kollektorbereichs die erste Epitaxieschicht zumindest teilweise an eine Silizidschicht an, um einen niederohmigen Anschluss dieser Epitaxieschicht zu ermöglichen.

Ein wiederum anderer Aspekt der Erfindung ist eine integrierte Kaskodenschaltung mit einem ersten Bipolartransistor und einem zweiten Bipolartransistor. Der erste Bipolartransistor weist einen ersten, durch eine erste Epitaxieschicht und eine zweite Epitaxieschicht aufgewachsenen Kollektorbereich eines ersten Leitungstyps auf. Analog weist der zweite Bipolartransistor einen zweiten, durch diese erste Epitaxieschicht und diese zweite Epitaxieschicht aufgewachsenen zweiten Kollektorbereich dieses ersten Leitungstyps auf.

Bevorzugt weist der der erste Kollektorbereich eine erste Kollektordriftzone und der zweite Kollektorbereich eine zweite Kollektordriftzone aufweist, wobei diese erste Kollektordriftzone gegenüber dieser zweiten Kollektor-driftzone durch unterschiedliche Dotierstoffprofile innerhalb der ersten Epitaxieschicht verkürzt ist. Um die Kaskodenfunktionalität zu erreichen, ist der erste Kollektorbereich des ersten Bipolartransistors mit einem zweiten Emitterbereich des zweiten Bipolartransistors elektrisch verbunden.

Im Folgenden wird die Erfindung anhand eines zeichnerisch dargestellten Ausführungsbeispiels näher erläutert.

### Dabei zeigen

- Fig. 1: eine schematisch Schnittdarstellung durch einen ersten Bipolartransistor und durch einen zweiten Bipolartransistor,
- Fig. 2a: einen schematischen Dotierstoffverlauf entlang der Schnittlinie a, und

- Fig. 2b: einen schematischen Dotierstoffverlauf entlang der Schnittlinie b.

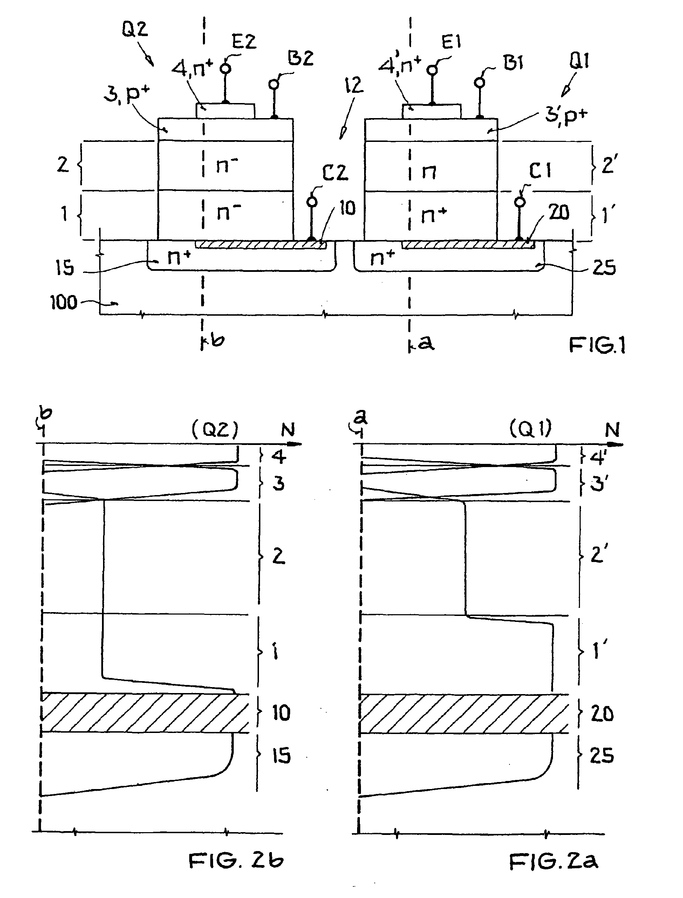

In der Fig. 1 sind zwei Bipolartransistoren Q1 und Q2 dargestellt. Im Folgenden werden beide Transistoren Q1 und Q2 als npn-Bipolartransistoren beschrieben. Die Erfindung ist jedoch durch einfachen Austausch der Leitungstypen auch für pnp-Bipolartransistoren gleichermaßen anwendbar. Die Halbleiterregionen 3' und 4' des ersten, linken Bipolartransistors Q1 der Fig. 1 sind in diesem Ausführungsbeispiel mit den jeweils entsprechenden Halbleiterregionen 3, 4 des zweiten, rechten Bipolartransistors Q2 identisch.

Der erste Transistor Q1 ist durch epitaktische Verfahren auf einem Substrat 100 erzeugt. Hierzu ist für einen niederohmigen Anschluss des Kollektors C1 eine hochdotierte Wanne 25 (8e19 cm⁻³) in das p-dotierte Substrat eingebracht und eine Silizidschicht 20 ausgebildet. Oberhalb der Silizidschicht 20 wird eine erste Kollektorepitaxieschicht 1' monokristallin beispielsweise durch Festphasenepitaxie von beispielsweise 70 nm Dicke aufgewachsen. In derselben Epitaxie wird zudem die Kollektorepitaxieschicht 1 (1e17 cm⁻³) des zweiten Kollektorbereichs (1, 2) des zweiten Transistors Q2 aufgewachsen. Auch dieser zweite Kollektorbereich (1, 2) des zweiten Transistors Q2 ist auf einer Silizidschicht 10 monokristallin aufgewachsen, wobei die Silizidschicht 10 wiederum auf einer in das Substrat 100 eingebrachten, hoch n-dotierten Wanne 15 (8e19 cm⁻³) zum Anschluss des Kollektors C2 des zweiten Transistors Q2 aufgebracht ist.

Weiterhin dienen die Silizidschichten 10, 20 als Festkörper-Dotierstoffquellen, mit deren Hilfe im weiteren Verlauf des Herstellungsprozesses in Randbereichen der hoch dotierten Wannen 15, 25 sowie der Kollektor-Epitaxieschichten 1, 1', die an die Silizidschichten 10, 20 angrenzen, eine Dotierstoffkonzentration von vorzugsweise mehr als 1 e20 cm⁻³ durch Ausdiffusion erzeugt wird.

Auf die erste Kollektorepitaxieschicht 1 beziehungsweise 1' folgt eine selektiven Implantation von Dotanden des ersten Leitungstyps in die Kollektorepitaxieschicht 1' des ersten Kollektorbereichs 1', so dass in dieser Kollektorepitaxieschicht 1' des ersten Kollektorbereichs 1' des ersten Transistors Q1 eine Dotierstoffkonzentration von 1 e19 cm⁻³ eingebracht wird. Nachfolgend wird eine zweite Kollektorepitaxieschicht 2 beziehungsweise 2' mit einer Dotierstoffkonzentration von 2e16 cm⁻³ aufgebracht. Diese zweite Kollektorepitaxieschicht 2, 2' grenzt in den Transistoren Q1 und Q2 an die Halbleiterregion 3', 3 (mit einer Dotierstoffkonzentration von beispielsweise 2e19 cm⁻³) der Basis B1 beziehungsweise B2 des jeweiligen Transistors Q1 beziehungsweise Q2. Beispielsweise weist diese zweite Kollektorepitaixeschicht 2, 2' eine Dicke von 50 nm auf. Durch eine selektive Implantation von Dotanden des ersten Leitungstyps wird zudem eine höhere Dotierstoffkonzentration in dieser zweiten Kollektorepitaxieschicht 2' des ersten Transistors Q1 gegenüber einer niedrigeren Dotierstoffkonzentration in dieser zweiten Kollektorepitaxieschicht 2 des zweiten Transistors Q2 erzeugt.

Die Basis-Halbleiterregion 3', 3 weist dabei vorzugsweise eine Silizium-Germanium-Schicht auf. Wiederum an die Basis-Halbleiterregion 3', 3 grenzt die Halbleiterregion 4', 4 des Emitters E1 beziehungsweise E2 des jeweiligen Transistors Q1 beziehungsweise Q2. Dabei sind in diesem Ausführungsbeispiel der Erfindung die erste Kollektorepitaxieschicht 1 bzw. 1', die zweite Kollektorepitaxieschicht 2 bzw. 2' und die Emitterschicht 4 bzw. 4' n-dotiert, während die Basisschicht 3, 3' p-dotiert ist.

Der Unterschied zwischen den Transistoren Q1 und Q2 ist ausschließlich durch die unterschiedlichen Dotierstoffkonzentrationen in den Kollektorepitaxieschichten 1 und 1', sowie 2 und 2' gegeben. Dies wird nachfolgend anhand der durch die Dotierstoffverläufe N(Q1) und N(Q2) entlang der Schnitte a und b gebildeten Dotierstoffprofile erläutert. Dabei verläuft der Schnitt a durch den ersten Bipolartransistor Q1, dargestellt in der Fig. 2a und der Schnitt b durch den zweiten Bipolartransistor Q2, dargestellt in der Fig. 2b.

Fig. 2a zeigt, dass die erste Kollektorepitaxieschicht 1' des ersten Transistors Q1 hoch n⁺-dotiert ist und einen quasimetallischen Anschluss der zweiten Kollektorepitaxieschicht 2' ermöglicht. Im Gegensatz zur ersten Kollektorepitaxieschicht 1' des ersten Transistors Q1 ist die erste Kollektorepitaxieschicht 1 des zweiten Transistors Q2 niedrig n⁻-dotiert, so dass sich die Kollektordriftzone des zweiten Transistors Q2 im Wesentlichen über die Dicke der ersten Kollektorepitaxieschicht 1 und zweiten Kollektorepitaxieschicht 2 erstreckt.

Zur höheren Dotierung der ersten Kollektorepitaxieschicht 1' des ersten Transistors Q1 gegenüber der ersten Kollektorepitaxieschicht 1 des zweiten Transistors Q2 ist eine Maske im Herstellungsverfahren vorgesehen, die eine selektive Implantation von Dotanden in die erste Kollektorepitaxieschicht 1' des ersten Transistors Q1 ermöglicht und eine Dotierung der ersten Kollektorepitaxieschicht 1 des zweiten Transistors Q2 verhindert.

Weiterhin ist die zweiten Kollektorepitaxieschicht 2' (5e17 cm⁻³) des ersten Transistors Q1 ebenfalls signifikant höher dotiert als die des zweiten Transistors Q2, um die Hochfrequenzeigenschaften des ersten Transistors Q1 gegenüber dem zweiten Transistor Q2 zu verbessern.

## Patentansprüche

1. Verfahren zur Herstellung einer integrierten Schaltung auf einem Halbleiterplättchen, wobei
- ein erster Bipolartransistor (Q1) mit einem ersten Kollektorbereich (1', 2') eines ersten Leitungstyps und
- ein zweiter Bipolartransistor (Q2) mit einem zweiten Kollektorbereich (1, 2) dieses ersten Leitungstyps erzeugt werden,
indem
- der erste Kollektorbereich (1', 2') durch eine erste Kollektorepitaxie und nachfolgend eine zweite Kollektorepitaxie aufgewachsen wird, und
- der zweite Kollektorbereich (1, 2) auch durch diese erste Kollektorepitaxie und diese zweite Kollektorepitaxie aufgewachsen wird, und
- in den ersten Kollektorbereich (1', 2') nach dieser ersten Kollektorepitaxie und vor dieser zweiten Kollektorepitaxie Dotanden des ersten Leitungstyps derart eingebracht werden, dass eine erste Dotierstoffkonzentration in einer durch diese erste Kollektorepitaxie aufgewachsenen ersten Epitaxieschicht (1') des ersten Kollektorbereichs (1', 2') eine zweite Dotierstoffkonzentration in einer durch diese erste Kollektorepitaxie aufgewachsenen ersten Epitaxieschicht (1) des zweiten Kollektorbereichs (1, 2) übersteigt.

2. Verfahren nach Anspruch 1, **dadurch gekennzeichnet, dass** in den ersten Kollektorbereich (1',2') nach der zweiten Kollektorepitaxie Dotanden des ersten Leitungstyps derart eingebracht werden, dass eine dritte Dotierstoffkonzentration in einer durch diese zweite Kollektorepitaxie aufgewachsenen zweiten Epitaxieschicht (2') des ersten Kollektorbereichs (1', 2') eine vierte Dotierstoffkonzentration in einer durch diese zweite Kollektorepitaxie aufgewachsenen zweiten Epitaxieschicht (2) des zweiten Kollektorbereichs (1, 2) übersteigt.

3. Verfahren nach einem der vorhergehenden Ansprüche, **dadurch gekennzeichnet, dass** an den ersten Kollektorbereich (1', 2') angrenzend ein erster Basisbereich (3') eines zweiten Leitungstyps mit einer Silizium-Germanium-Schicht aufgebracht wird und/oder an den zweiten Kollektorbereich (1, 2) angrenzend ein zweiter Basisbereich (3) eines zweiten Leitungstyps mit einer Silizium-Germanium-Schicht aufgebracht wird.

4. Verfahren nach einem der vorhergehenden Ansprüche, **dadurch gekennzeichnet, dass** zum selektiven Einbringen eine Maske aufgebracht und die Dotanden implantiert werden.

5. Verfahren nach einem der vorhergehenden Ansprüche, **dadurch gekennzeichnet, dass** die erste Kollektorepitaxie eine laterale Festphasenepitaxie ist, wobei amorphes Silizium auf einer Silizidschicht (10, 20) und auf ein monokristallines Siliziumsubstrat (100) aufgebracht und in einem Temperschritt ausgehend von dem als Kristallisationskeim wirkenden monokristallinem Siliziumsubstrat (100) auskristallisiert wird.

6. Integrierte Schaltung auf einem Halbleiterplättchen, mit
- einem ersten Bipolartransistor (Q1) und
- einem zweiten Bipolartransistor (Q2),
wobei
- der erste Bipolartransistor (Q1) einen ersten, durch eine erste Epitaxieschicht (1') und eine zweite Epitaxieschicht (2') aufgewachsenen Kollektorbereich (1', 2') eines ersten Leitungstyps aufweist, und
- der zweite Bipolartransistor (Q2) einen zweiten, durch diese erste Epitaxieschicht (1) und diese zweite Epitaxieschicht (2) aufgewachsenen zweiten Kollektorbereich (1, 2) dieses ersten Leitungstyps aufweist,
- der erste Kollektorbereich (1', 2') eine erste Kollektordriftzone und der zweite Kollektorbereich (1, 2) eine zweite Kollektordriftzone aufweist, und
- diese erste Kollektordriftzone gegenüber dieser zweiten Kollektor-driftzone **dadurch** verkürzt ist, dass die erste Epitaxieschicht (1') des ersten Kollektorbereichs (1', 2') eine höhere Dotierstoffkonzentration als die erste Epitaxieschicht (1) des zweiten Kollektorbereichs (1, 2) aufweist.

7. Integrierte Schaltung nach Anspruch 6, **dadurch gekennzeichnet, dass** die zweite Epitaxieschicht (2') des ersten Kollektorbereichs (1', 2') eine höhere Dotierstoffkonzentration als die zweite Epitaxieschicht (2) des zweiten Kollektorbereichs (1, 2) aufweist.

8. Integrierte Schaltung nach einem der Ansprüche 6 oder 7, **dadurch gekennzeichnet, dass** der erste Kollektorbereich (1', 2') unmittelbar an eine Silizium-Germanium-Schicht eines ersten Basisbereiches (3) eines zweiten Leitungstyps des ersten Bipolartransistors (Q1) grenzt und/oder der zweite Kollektorbereich (1, 2) unmittelbar an eine Silizium-Germanium-Schicht eines zweiten Basisbereiches (3) des zweiten Leitungstyps des zweiten Bipolartransistors (Q2) grenzt.

9. Integrierte Schaltung nach einem der vorhergehenden Ansprüche, **dadurch gekennzeichnet, dass** innerhalb des ersten Kollektorbereichs (1', 2') und/oder innerhalb des zweiten Kollektorbereichs (1, 2) die erste Epitaxieschicht (1', 1) zumindest teilweise an eine Silizidschicht (10, 20) angrenzt.

10. Integrierte Kaskodenschaltung mit
- einem ersten Bipolartransistor (Q1) und
- einem zweiten Bipolartransistor (Q2),
wobei
- der erste Bipolartransistor (Q1) einen ersten, durch eine erste Epitaxieschicht (1') und eine zweite Epitaxieschicht (2') aufgewachsenen Kollektorbereich (1', 2') eines ersten Leitungstyps aufweist, und
- der zweite Bipolartransistor (Q2) einen zweiten, durch diese erste Epitaxieschicht (1) und diese zweite Epitaxieschicht (2) aufgewachsenen zweiten Kollektorbereich (1, 2) dieses ersten Leitungstyps aufweist,
- der erste Kollektorbereich (1', 2') eine erste Kollektordriftzone und der zweite Kollektorbereich (1, 2) eine zweite Kollektordriftzone aufweist,
- diese erste Kollektordriftzone gegenüber dieser zweiten Kollektor-driftzone **dadurch** verkürzt ist, dass die erste Epitaxieschicht (1') des ersten Kollektorbereichs (1', 2') eine höhere Dotierstoffkonzentration als die erste Epitaxieschicht (1) des zweiten Kollektorbereichs (1, 2) aufweist, und
- der erste Kollektorbereich (1', 2') des ersten Bipolartransistors (Q1) mit einem zweiten Emitterbereich (4) des zweiten Bipolartransistors (Q2) elektrisch verbunden ist.

11. Integrierte Kaskodenschaltung nach Anspruch 10, **dadurch gekennzeichnet, dass** die zweite Epitaxieschicht (2') des ersten Kollektorbereichs (1', 2') eine höhere Dotierstoffkonzentration als die zweite Epitaxieschicht (2) des zweiten Kollektorbereichs (1, 2) aufweist.
